# EUROPEAN PATENT APPLICATION

(11) **EP 2 953 432 A1**
(43) Date of publication of application: **09.12.2015**
(21) Application number: 14305979.8
(22) Date of filing: 23.06.2014
(51) Int. Cl.: H05K 1/02, H01P 1/02, H01P 3/02

(54) **Locally compensating signal skew in printed circuit boards**

(30) Priority: 23.05.2014 US 201462002483 P
(71) Applicant: Alcatel Lucent, 92100 Boulogne-Billancourt (FR)
(72) Inventor: Gadeyne, Koen, 2018 Antwerpen (BE); Hooghe, Koen, 2018 Antwerpen (BE); Kozicki, Bartlomiej, 2018 Antwerpen (BE)
(74) Representative: ALU Antw Patent Attorneys

(57) **Abstract**

An apparatus (10) includes a printed circuit board. The printed circuit board includes a group of metal traces (12) located along a surface or interface of the printed circuit board and a dielectric layer (20). The metal traces of the group are parallel in a sequence common straight zones (16) and are bent in a common direction in a local common bend zone (18) located between two of the common straight zones. In and next to the local common bend zone, said same dielectric layer is in contact with a longer segment of one of the metal traces than of another of the metal traces of the group.

## Description

### Field of the Invention

The present invention generally relates to printed circuit boards (PCBs) and methods of fabricating and using PCBs.

### Background

This section introduces aspects that may be helpful to facilitating a better understanding of the inventions. Accordingly, the statements of this section are to be read in this light and are not to be understood as admissions about what is in the prior art or what is not in the prior art.

For various applications, printed circuit boards often include one or more groups of metal traces with substantially parallel paths. Such substantially parallel paths often have one or more local turning or bend zones thereon. Herein, a local common bend zone is a local region in which the metal traces of a group are not straight. In such a local common bend zone, all the metal traces of the group may bend to the left as traversed in one direction or may alternatively bend to the right as traversed in that direction.

The electrical signals transferred over such an approximately parallel group of metal traces may be related. For example, the electrical signals carried by a pair of metal traces may be generated as a differential pair. Herein, a differential pair of electrical signals is a pair of electrical signals of the same magnitude and opposite voltage.

On a printed circuit board (PCB), the metal traces of such a group often have similar, but not exactly equal lengths. For this reason, the propagation of electrical signals over the metal traces of the group may introduce relative time-delays between the electrical signals carried by the different metal traces therein. Thus, a group of electrical signals, which are initially synchronized, at the adjacent first ends of the group of metal traces are often not completely synchronized when the electrical signals arrive at the second ends of such a group of metal traces. The de-synchronization of an initially synchronized group of electrical signals is referred to as skew.

The presence of skew is typically undesired and may interfere with appropriate electronic processing. For example, excessive skew may impede the ability of an electronic receiver to extract a data stream from the electrical signals delivered by a pair of metal traces when the data was initially transmitted to the pair of metal traces as a differential pair of electrical signals. The undesired effects of skew are typically more serious at higher data rates where the same amount of skew is relatively larger when measured as a number of data symbol periods.

### Summary of Example Embodiments

Various embodiments provide a circuit board on which a group of nearby metal traces have substantially parallel paths. The circuit board is made to locally adjust propagation speed(s) of electrical signals on one or more of the metal traces at and/or adjacent local common bend zone(s) for the group. Such local adjustment can partially and locally compensate for length differences between the metal traces of the group in and/or adjacent the local common bend zone(s). Such local compensation of length differences can reduce the generation of skew between electrical signals on the different metal traces of the same group. Since the compensation is performed locally near and/or at zone(s) where relative path length differences are produced, straight zones of metal traces with substantially parallel paths should generate less cross talk between "skewed" electrical signals on different ones of the metal traces of the same group.

In a first embodiment, an apparatus includes a circuit board. The printed circuit board includes a group of metal traces located along a surface or interface of the printed circuit board and a dielectric layer. The metal traces of the group are parallel in a sequence common straight zones and are bent in a common direction in a local common bend zone located between two of the common straight zones. In and next to the local common bend zone, said same dielectric layer is in contact with a longer segment of one of the metal traces than of another of the metal traces of the group.

In some embodiments of the above apparatus, in the local common bend zone, the one of the metal traces may be relatively located more towards a bending direction of the metal traces therein than the another of the metal traces.

In some embodiments of the above apparatus, the metal traces of the group may be fabricated of the same metal and have the about same cross sectional area.

In any of the above embodiments, the dielectric layer may have a dielectric constant of about 10 or more or even 15 or more and/or may include metal oxide.

In any of the above embodiments, the dielectric layer may include copper oxide and the metal traces may include copper.

In any of the above embodiments, the group may include at least three of the metal traces. In such embodiments, the apparatus may further include a digital data bus located on the printed circuit board and including the group of metal traces. In some such embodiments, the apparatus may further include a digital data processor module and a data memory module located on the printed circuit board and connected to communicate by the digital data bus.

In some of the above embodiments, the apparatus may further include a first electronic module and a second electronic module. Then, the first and second electronic modules are located on the printed circuit board, wherein the metal traces of the group electrically connect a pair of differential signal outputs of the first electronic module to a pair of differential signal inputs of the second electronic module in a one-to-one manner.

In some embodiments of the above apparatus, the dielectric layer, in and/or next to the local common bend zone, is in contact with a shorter segment of a third of the metal traces than the one of the metal traces, and the dielectric layer is in contact with a longer segment of third of the metal traces than the another of the metal traces.

In some of the above embodiments, the metal traces of the group pass through a second local common bend zone in which the metal traces bend in the same direction, and in the second local common bend zone, a dielectric layer is in contact with a longer segment of one of the metal traces of the group than another of the metal traces of the group.

In other embodiments, a process for manufacturing a printed circuit board includes providing on a substrate the group of metal traces and forming a layer of dielectric over part of the circuit board. The metal traces of the group are parallel in a sequence of common straight zones and have bends in a same direction in a local common bend zone located between and adjacent to two of the common straight zones. The forming a layer of dielectric is performed such that a segment of one of the metal traces is covered by the dielectric in or next to the local common bend zone and another of the metal traces is not covered by the same dielectric in or next to the local common bend zone.

In some embodiments of the process, in the local common bend zone, the one of the metal traces is relatively located more along a bending direction of the metal traces than the another of the metal traces.

In some embodiments of the process, the dielectric has a dielectric constant of about 10 or more or even 15 or more.

### Brief Description of the Drawings

Figure 1 is a top view illustrating an embodiment that includes a portion of a printed circuit board (PCB) having a pair of substantially parallel and nearby metal traces thereon;
Figure 2 is a top view illustrating another embodiment that includes a portion of a PCB having a group of three substantially parallel and nearby metal traces thereon;
Figure 3 is a top view illustrating another embodiment of a PCB having a group of N substantially parallel metal traces and multiple local common bend zones;
Figure 4 is a cross-sectional view illustrating the local common bend zone of Figure 1;
Figure 5 is a cross-sectional view illustrating an example of the local common bend zone of Figure 4;
Figure 6 is a cross-sectional view illustrating the local common bend zone of Figure 2;
Figure 7 provides top views illustrating example shapes for a metal trace in a local common bend zone, e.g., any of the local common bend zones of Figures 1 - 3;
Figure 8 is a top view of a PCB with two electronic modules thereon; and
Figure 9 is a flow chart illustrating a process for manufacturing a PCB, e.g., any of the PCBs of Figures 1 - 3.

### Description of Illustrative Embodiments

Herein PCBs may have one or more layers and metal traces may be formed on the top surface of the PCB, the bottom surface of the PCB, and/or one or more interfaces between the layers of a multilayer PCB.

In various embodiments, a PCB has a group of two or more metal traces on the surface or interface of the PCB, and the metal traces of the group have substantially parallel and nearby paths on the PCB. Herein, a physical layout of the metal traces of such a group will be described by a sequence of zones, which covers that part of the surface or interface of a PCB on which the metal traces are located. In such a sequence, a zone only overlaps with an adjacent zone of the sequence on a boundary segment thereof. The sequence of zones typically includes a first local contact zone, one or more common straight zones, one or more local common bend zone(s), and a second local contact zone. The common straight zones may be parallelograms, e.g., rectangles, with two sides parallel to the metal traces of the group. In the various Figures, the boundaries of such zones may be indicated by dashed lines or braces.

The first and second local contact zones are electrically connected by the metal traces of the group. That is, the metal traces of the group have first ends in the first local contact zone and have second ends in the second local contact zone. In a local contact zone, the various metal traces of the group physically connect to metal contact pads for electronic module(s) and/or active electronic devices, e.g., connect via solder junction to the metal contact pads.

Often, the metal traces of such a group will have about the same length in a local contact zone. Alternately, a local contact zone may be small so that differences between the metal traces of the group have, at most, small length differences in the local contact zone. Thus, a local contact zone often does not produce substantial skew between electrical signals propagating on the different metal traces of such a group. In other situations, the skew produced at a local contact zone may be locally compensated, e.g., by pin or lead lengths or contact pad sizes for an electronic module physically connected in that contact zone. Thus, if electrical signals are synchronized at initial transmission to the different metal traces of a group at a local contact zone, the electrical signals on the different metal traces of the group are typically still synchronized at the boundary of the local contact zone.

The common straight and local common bend zones electrically and physically connect the first local contact zone to the second local contact zone.

In a common straight zone, the individual metal traces of the group have about the same length and are parallel or about parallel. In some embodiments, one linear dimension of a common straight zone may be, e.g., much larger than the orthogonal linear dimension along the surface or interface of the PCB. A common straight zone does not typically produce skew between electrical signals propagating on the different metal traces of the group, because the metal traces of the group have about the same length therein.

In a local common bend zone, the paths of the metal traces of the same group change direction the same sense or the same direction. For example, in one path-direction, all metal traces of the group bend to the left on the surface or interface of the PCB or all metal traces of the group bend to the right on the surface or interface of the PCB. In such a zone, the individual metal traces of the group typically have different lengths. For example, a metal trace located to the left of another metal trace of the group is typically shorter in a local common bend zone in which the metal traces bend to the left, and a metal trace located to the right of another metal trace of the group is typically shorter in a local common bend zone in which the metal traces bend to the right. That is, in the local common bend zone, a metal trace relatively located more along the sense or direction of the bend typically has a shorter length than a metal trace of the same group, which is located less along the sense or direction of the bend. Thus, a local common bend zone may locally skew the electrical signals on different ones of the metal traces of the same group unless a structural feature compensates for the relative length differences between the metal traces therein.

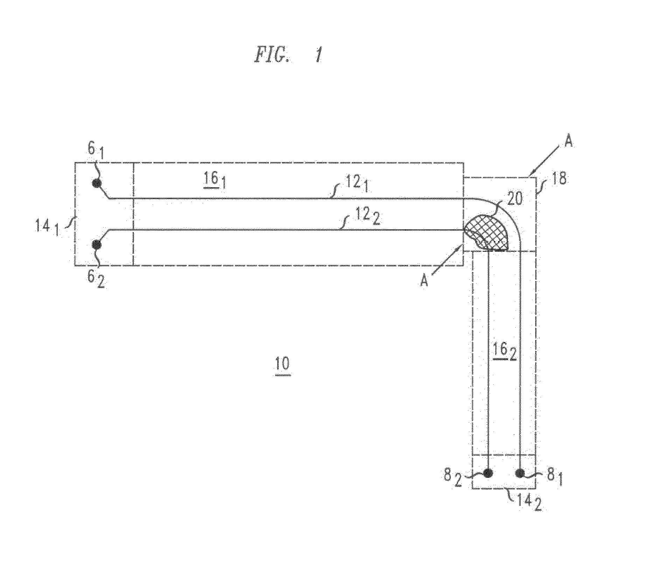

Below, Figures 1 - 6 illustrate various embodiments of PCBs and describe example physical layouts of metal traces thereon. The various embodiments include structural feature(s) that locally compensate for, at least, part of the skew that would otherwise be produced between metal traces of a substantially parallel group thereof in one or more local common bend zone(s).

In Figures 1 - 6, the different metal traces of a substantially parallel group may or may not be formed of the same metal.

In Figures 1 - 6, the different metal traces of a substantially parallel group may or may not have cross sections of similar or the same shape and/or area.

Figure 1 illustrates an embodiment of a PCB in which a pair of metal traces 12₁, 12₂ are located on a surface or interface 10 of the PCB. The metal traces 12₁, 12₂ electrically connect a first pair of nearby metal contact pads 6₁, 6₂ to a second pair of nearby metal contact pads 8₁, 8₂ in a one-to-one manner. The first pair of metal contact pads 6₁, 6₂ is remotely located from the second pair of metal contact pads 8₁, 8₂. The metal traces 12₁, 12₂ follow nearby and substantially parallel paths on the surface or interface 10 of the PCB.

To connect the first pair of metal contact pads 6₁, 6₂ to the relatively remote second pair of metal contact pads 8₁, 8₂, the paths of the two metal traces 12₁, 12₂ pass through a sequence of non-overlapping rectangular zones. The sequence include a first local contact zone 14₁, a first common straight zone 16₁, a local common bend zone 18, a second common straight zone 16₂, and a second local contact zone 14₂. Each zone 14₁, 16₁, 18, 16₂, 14₂ defines a pair of segments of the two metal traces 12₁, 12₂ located therein. In Figure 1, boundaries of the zones are indicated by dashed lines, but the dashed lines are typically not actual features on the PCB. Here, the boundaries of a zone intersect the metal traces of a substantially parallel and nearby group perpendicular to the paths made by the metal traces of the group.

In Figure 1, the rectangular zones 14₁,16₁, 18, 16₂, 14₂ indicate local origins of relative path length differences between the two metal traces zone 12₁, 12₂ as explained below.

First, neither the first local contact zone 14₁ nor the first straight zone 16₁ typically cause a significant relative length difference between the first and second metal traces 12₁, 12₂. That is, the segment of the first metal trace 12₁ between the first contact 6₁ and the closest boundary of the local common bend zone 18 has about the same length as the segment of the second metal trace 12₂ between the other first contact 6₂ and the closest boundary of the local common bend zone 18. Second, neither the second local contact zone 14₂ nor the second straight zone 16₂ causes any relative length difference between the first and second metal traces 12₁, 12₂. That is, the segment of the first metal trace 12₁ between the second contact 8₁ and the closest boundary of the bend zone 18 has about the same length as the segment of the second metal trace 12₂ between the other second contact 8₂ and the closest boundary of the bend zone 18. Third, the local common bend zone 18 introduces a relative length difference between the first and second metal traces 12₁, 12₂. That is, in the local common bend zone 18, the segment of the first metal trace 12₁ which is located more to the outside of the "pair of metal trace bends" of the local common bend zone 18, is longer than the segment of the second metal trace 12₂, which is located more to the inside of the "pair of metal trace bends" of the local common bend zone 18.

As already discussed and specifically illustrated in Figure 1, metal traces of a substantially parallel and nearby group can be easily designed to have about the same lengths in local contact zones and common straight zones, but will typically have different lengths in local common bend zone(s). Whereas one of the metal traces of such a group could be given a more complex layout in a bend zone to eliminate such a relative length difference, such an approach to reducing or eliminating skew may cause other undesired effects, e.g., the production of electrical signal reflections and/or complex impedances due to the complex shape of the metal trace. Thus, the inventors have found an alternate technique for managing the production of skew between the metal traces of a substantially parallel and nearby group in a local common bend zone. That technique involves slowing the average propagation speed(s), in or near the local common bend zone, of electrical signals on the shorter of the metal traces relative to the propagation velocity of electrical signals on the longer of the metal traces.

In particular, the electromagnetic fields of an electrical signal propagate in a hybrid medium formed by a metal trace and the physically adjacent dielectric(s). The form, placement, and composition of the adjacent dielectric(s) can affect the propagation velocity of electrical signals along the metal trace. For example, the presence of dielectric material with a high dielectric constant adjacent to or in contact with a segment of a metal trace may significantly slow the propagation velocity of electrical signals along that segment of a metal trace with respect to the propagation velocity of electrical signals along the segment in the absence of the dielectric material with a high dielectric constant.

In various embodiments, different metal traces of such a substantially parallel and nearby group have different patterns of nearby dielectric in or near one or more local common bend zone(s), e.g., the local common bend zone 18 of Figure 1. For example, in or adjacent to a local common bend zone, a dielectric may cover a segment of one of the metal traces of the group and not cover another metal trace of the same group. Then, in or adjacent to the local common bend zone, the patterning of dielectric can, e.g., be used to slow the propagation velocity of electrical signals on one or more of the metal traces of the group relative to the propagation velocity of electrical signals on other metal trace(s) of the same group. Herein, such dielectric patterning is typically used to locally slow a propagation velocity along segment(s) of the metal trace(s) of the group that are shorter in the local common bend zone. Such selective relative slowing of the electrical signals on one or more of the substantially parallel metal traces of such a group can locally, partially or completely compensate for path length differences between the different metal traces of the group in the local common bend zone. In this manner, the compensation can locally reduce production of skew between the electrical signals carried by different ones of the metal traces of such a substantially parallel and nearby group of metal traces so that skew does not accumulate along the metal traces.

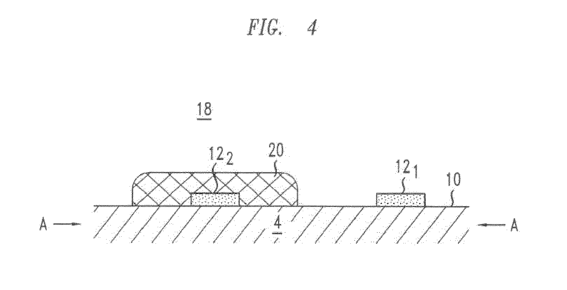

In the local common bend zone 18 of Figure 1, origins of differences between propagation velocities of electrical signals on the first and second metal traces 12₁,12₂ may be more completely illustrated by a cross-sectional along line A-A as shown in Figure 4.

In the local common bend zone 18, the metal traces 12₁, 12₂ are located on the surface or interface 10 of the PCB's substrate 4. Also, a segment of the second metal trace 12₂, which has a shorter length in the local common bend zone 18, is in contact with and/or covered by a dielectric layer 20 in the same bend zone 18. The same dielectric layer 20 is not in contact with and does not cover the first metal trace 12₁, which is relatively longer in the local common bend zone 18. In some embodiments, a layer of a different dielectric (not shown) may cover and be in contact with the first metal trace 12₁, but the different dielectric would typically have a dielectric constant of different value, e.g., typically a lower value, than the dielectric of the dielectric layer 20.

The dielectric layer 20, in contact with or covering the segment of the second metal trace 12₂, lowers the average propagation velocity of electrical signals therein for reasons already described. Thus, in the local common bend zone 18, the selectively patterned distribution of dielectric covering, i.e., with respect to the two metal traces 12₁, 12₂ causes a relative difference in the propagation velocities of electrical signals in the first and second metal traces 12₁, 12₂. The composition, depth and length of dielectric layer 20, which covers the segment of the metal trace 12₂, can be configured to locally reduce or eliminate skew production, which would otherwise occur, due to the path length differences between the first and second metal traces 12₁, 12₂ in the local common bend zone 18.

If alternatively to such local compensation, skew were compensated globally by adding length(s) to initial or final end(s) of the shorter metal trace(s) of a group of substantially parallel and nearby metal traces, skew could still degrade electrical signals on the metal traces of the group. In particular, in common straight zone(s), the electrical signals on laterally adjacent segments of such metal traces could then accumulate significant skew. In long common straight zone(s), such skewing of the electrically signals could lead to significant signal degradation via crosstalk, e.g., preventing a receiver from properly decoding electrical signals received at final ends of the metal traces. In contrast, various embodiments partially or completely compensate for skew locally next to and/or in the local common bend zone(s) where skew would otherwise be produced. For that reason, little crosstalk occurs between skewed electrical signals on adjacent and nearby segments of substantially parallel metal traces. Such a local management of production of skew may be particularly advantageous when the metal traces of such a group carry electrical signal streams with high symbol rates and/or when such a group includes a pair of such metal traces that receive a differential pair of electrical signals for delivery to an electronic device with differential inputs.

In alternate embodiments, the dielectric layer 20 may cover a straight segment of similar length of the second metal trace 12₂, which is located next to or just outside either boundary of the local common bend zone 18 rather than being inside the local common bend zone 18. Such a small displacement of where electrical signals are slowed on the second metal trace 12₂ may still provide an effective local compensation of skew production.

In alternate embodiments, the dielectric layer 20 may cover a straight segment of the second metal trace 12₂, which is located next to or just outside either boundary or both boundaries of the local common bend zone 18 as well as a segment of the second metal trace 12₂ inside the local common bend zone 18. Again, such a small displacement of where electrical signals are slowed on the second metal trace 12₂ may still provide an effective local compensation of skew production.

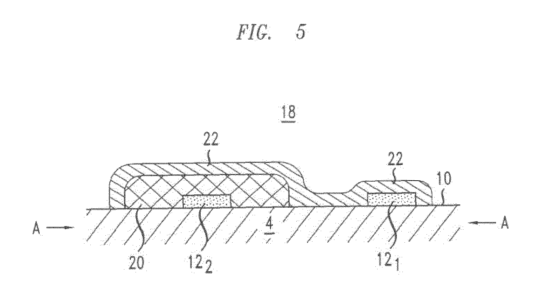

The dielectric layer 20 may be formed of various types of dielectric materials. For example, the dielectric layer 20 may be a conventional dielectric used in micro-electronics and/or printed circuit board technologies. To sufficiently slow the propagation velocity of electrical signals in the shorter segment of the second metal trace 12₂, it may be advantageous for the material of the dielectric layer 20 to have a high dielectric constant. Herein, a dielectric constant of 10 or more is a high dielectric constant, and high dielectric constants may even have value of 15 or more. For example, some copper oxides have a dielectric constant of about 18.1, which is much higher value than the values of dielectric constants of many dielectrics used in PCB substrates. Indeed, the dielectric layer 20 may include an oxide of a metal of the second metal trace 12₂. If the metal traces 12₁, 12₂ are formed of copper or alloys thereof, the dielectric layer 20 may include, e.g., a copper oxide grown by a selective patterned exposure of a segment of the second metal trace 12₂ to air or another conventional oxidizing agent. Figure 5 illustrates a specific embodiment of the local common bend zone 18 of Figure 4. In this embodiment, segments of both metal traces 12₁, 12₂ are covered with a second dielectric layer 22 in the local common bend zone 18. In addition, the second metal trace 12₂ has a segment that is also covered with the first dielectric layer 20, which may have a higher dielectric constant than the dielectric of the dielectric layer 22. A higher dielectric constant of the dielectric layer 20 would typically cause the average propagation velocity of electrical signals to be slower in the second metal trace 12₂ than in the first metal trace 12₁ in the local common bend zone 18. Such a configuration in which the dielectric coverings of the first and second metal traces 12₁, 12₂ are different can also locally partially or completely compensate for skew production due to length differences between the two metal traces 12₁, 12₂ in the local common bend zone 18.

For example, such an embodiment may be made by selective patterned oxidation of the metal of the shorter metal trace 12₂ to produce the dielectric layer 20. Then, both metal traces 12₁, 12₂ may be further covered with dielectric of the dielectric layer 22 to produce a hermetic protective coating, e.g., via a solder mask. That is, the dielectric layer 22 may be configured to prevent further oxidation of either metal trace 12₁, 12₂.

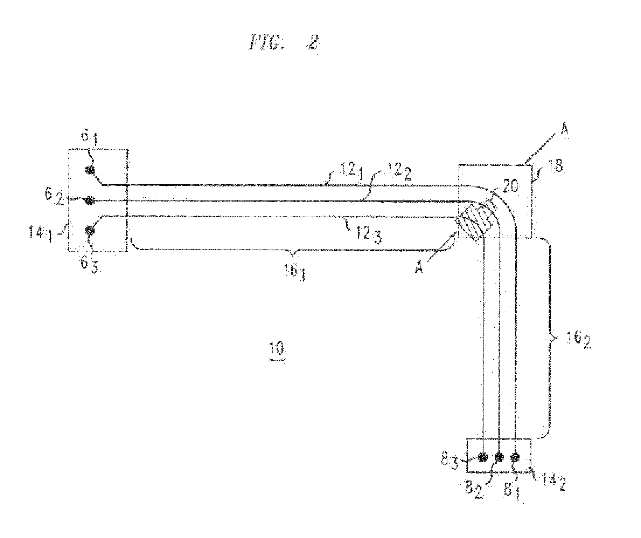

Figures 2 - 3 illustrate embodiments in which a group of substantially parallel and nearby metal traces on the PCB may include two or more such metal traces.

Figure 2 illustrates an embodiment of a PCB that includes a group of three substantially parallel and nearby metal traces 12₁, 12₂, 12₃ on a surface or interface 10 of the PCB. Each metal trace 12₁, 12₂, 12₃ is connected to carry electric signals between a corresponding input metal contact pad 6₁, 6₂, 6₃ and a corresponding output metal contact pad 8₁, 8₂, 8₃. The three input contact pads 6₁, 6₂, 6₃ are in a first local contact zone 14₁ remote from a second local contact zone metal trace 14₂ including the three output contact pads 8₁, 8₂, 8₃. The group of substantially parallel and nearby metal traces 12₁, 12₂, 12₃ have paths that pass through the first local contact zone 14₁, a first common straight zone 16₁, a local common bend zone 18, a second common straight zone 16₂, and the second local contact zone 14₂. The three metal traces 12₁, 12₂, 12₃ have about the same length in the first local contact zone 14₁, have about the same length in the first common straight zone 16₁, have about the same length in the second common straight zone 16₂, and have about the same length in the second local contact zone 14₂. Thus, the differences between the lengths of the three metal traces 12₁, 12₂, 12₃ of the group are produced locally in the local common bend zone 18.

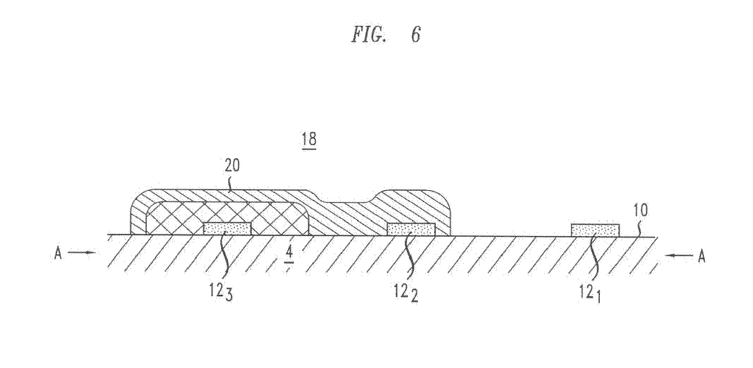

In and/or next to the local common bend zone 18, a dielectric layer 20 is patterned to cover and be in contact with segment(s) of some of the metal traces 12₁, 12₂, 12₃ of the group. In particular, the dielectric layer 20 is patterned to differently cover the three metal traces 12₁, 12₂, 12₃ in the local common bend zone 18. As illustrated in Figures 2 and 6, the dielectric layer 20 covers segments of the two metal traces 12₃, 12₂ with shortest and next shortest lengths in the local common bend zone 18, but does not cover any segment of the metal trace 12₁ with the longest length in the bend zone 18. In addition, as shown in Figure 2, the dielectric layer 20 covers a longer segment of the shortest metal trace 12₃ in the local common bend zone 18 than the next-shortest metal trace 12₂ therein.

Due to the selective patterning of the dielectric layer 20, electrical signals have the lowest average velocity, in the local common bend zone 18, on the metal trace 12₃ of shortest length therein and have the next lowest average velocity, in the local common bend zone 18, on the metal trace 12₂ of next shortest length therein. On the metal trace 12₁ of longest length in the local common bend zone 18, electrical signals have the highest average velocity in the local common bend zone 18. The differences between such average velocities in the local common bend zone 18 are due to the differences between the coverage of the three metal traces 12₁, 12₂, 12₃ by the patterned dielectric layer 20. The coverage by the dielectric layer 20 may be configured so that electrical signals traverse the local common bend zone 18 in about the same time on all three of the metal traces 12₁, 12₂,12₃ of the group. For such a preset configuration, electrical signals on the three metal traces 12₁, 12₂, 12₃, which are synchronized at their entry to the local common bend zone 18, will still be synchronized at their departure from the local common bend zone 18. As already discussed, such a local maintenance of synchronization of electrical signals along the substantially parallel metal traces 12₁, 12₂, 12₃ may be advantageous at high symbol rates and may reduce the production of undesirable types of cross talk.

In various embodiments, the dielectric layer 20 of Figure 2 may include a dielectric material similar to or the same as the dielectric used in the layer 20 of Figures 1 and 4. For example, the dielectric layer 20 may be formed of a dielectric of high dielectric constant and/or may include an oxide of a metal of the metal traces 12₂, 12₃.

In some embodiments, a second dielectric of lower dielectric constant may cover all of the substantially parallel metal traces 12₁, 12₂, 12₃ of the same group. For example, the second dielectric may be a hermetic protective layer that prevents further oxidation of the metal of the metal traces 12₁, 12₂, 12₃ as discussed with respect to the embodiment of Figure 5. Such a protective dielectric layer may be useful to ensure that the dielectric layer 20 of Figure 2 does not age in a manner that causes the local production of skew to increase with time.

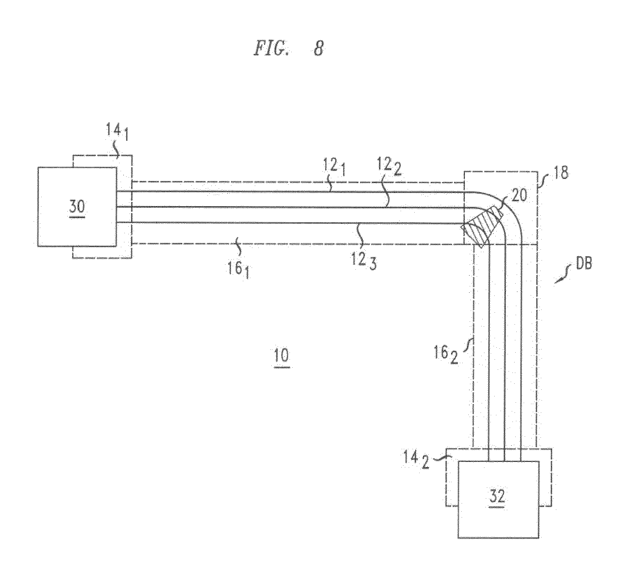

Referring to Figure 2, a PCB with such a group of more than two substantially parallel metal traces may be useful in a variety of applications. For example, Figure 8 illustrates an embodiment of the PCB of Figure 2 in which the metal traces 12₁, 12₂, 12₃ form part of a data bus (DB). The data bus DB provides a communications connection between two digital electronic modules 30, 32 located on the surface or interface 10 of the PCB, e.g., a digital data processor chip and a digital electronic memory or a digital data hard drive. In such an embodiment, the local management of skew production may be useful to enable the digital electronic modules 30, 32 to operate and/or communicate at high data rates. Indeed, an alternate solution that would meander one or more metal traces of the substantially parallel group in the local common bend zone 18 could degrade the carried electrical signals thereby interfering with the operation of the digital electronic devices 30, 32, at high data rates and/or may require a larger footprint for the metal traces 12₁, 12₂, 12₃ on the PCB than the examples herein.

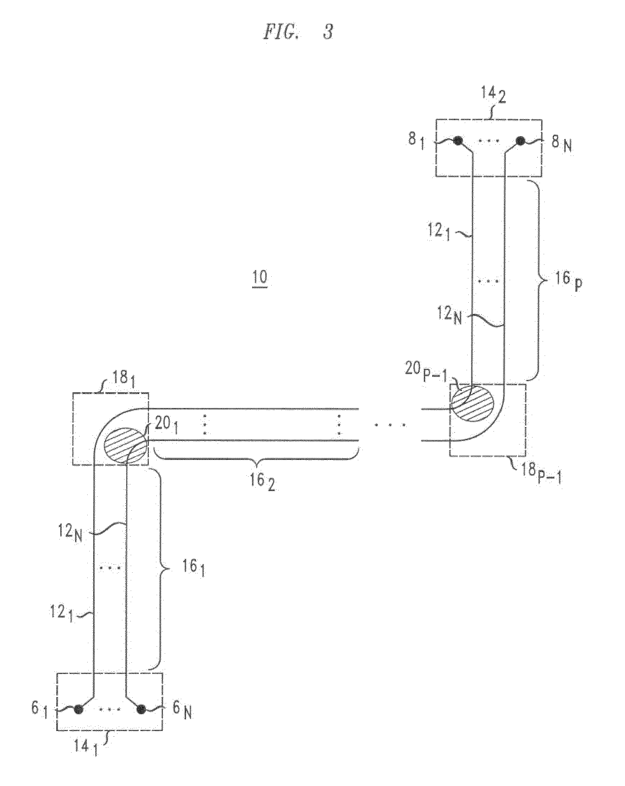

Figure 3 illustrates another embodiment of a PCB having a group of N metal traces 12₁, ..., 12_{N} on a surface or interface 10 thereof. The N metal traces 12₁ - 12_{N} have nearby and substantially parallel paths on the surface or interface 10. Here, N may be any integer equal to or greater than 2.

Each of the N metal traces 12₁ - 12_{N} is connected to carry electric signals between a corresponding one of N input metal contact pads 6₁, ..., 6_{N} and a corresponding one of N output metal contact pads 8₁, ..., 8_{N}. The N input metal contact pads 6₁ - 6_{N} are near to each other in a first local contact zone 14₁ and are remote from the N output metal contact pads 8₁ - 8_{N}, which are near to each other in a second local contact zone 14₂. The N metal traces 12₁ - 12_{N} pass through a sequence of P common straight zones 16₁, 16₂, ..., 16_{P} and (P-1) local common bend zones 18₁, ..., 18_{P-1}, which connect adjacent ones of the common straight zones 16₁ - 16_{P}. The N metal traces 12₁ - 12_{N} have about the same length in the local contact zones 14₁ 14₂ and the common straight zones 16₁ - 16_{P}, but typically have different lengths in the local common bend zones 18₁ - 18_{P-1}. Thus, each local common bend zone 18₁ - 18_{P-1} typically introduces local length difference(s) between the N metal traces 12₁ - 12_{N} of the substantially parallel group.

To locally compensate relative length differences, the N metal traces 12₁ - 12_{N} are differently covered by dielectric layers 20₁, ..., 20_{P-1} in the individual local common bend zones 18₁ - 18_{P-1}. Each dielectric layer 20₁ - 20_{P-1} may be, e.g., patterned to cover segments of the metal trace 12₁ - 12_{N} with the shortest length in the same local common bend zone 18₁ - 18_{P-1} and to not cover the metal trace 12₁ - 12_{N} with the longest length therein. Each dielectric layer 20₁ - 20_{P-1} may also be, e.g., patterned to cover segments of the metal trace(s) 12₁ - 12_{N} of intermediate length in the same local common bend zone 18₁ - 18_{P-1} differently so that the metal trace(s) 12₁ - 12_{N} of shorter length therein have longer segments covered by the dielectric layer 20₁ - 20_{P-1}. Such patterning of the dielectric layers 20₁ - 20_{P-1} may again be selected to locally compensate for some or all of the skew that would be otherwise locally produced by the path length differences between the N metal traces 12₁ - 12_{N}.

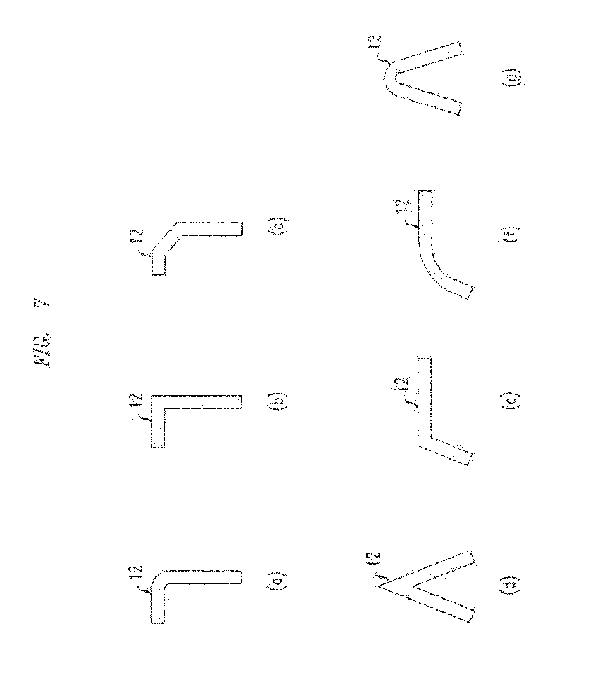

Figure 7 illustrates examples a, b, c, d, e, f, and g for shapes of a metal trace 12 in a local common bend zone, e.g., in local common bend zones 18 and 18₁ - 18_{P-1} Figures 1 - 3. In a local common bend zone, the metal trace 12 may have a smoothly curved bend as in example (a), a sharp right angle bend as in example (b), a bend formed by multiple straight segments as in example (c), a sharp bend through an acute angle as in example (d), a sharp bend through an obtuse angle as in example (e), a smoothly curved bend through an obtuse angle as in example (f), or a smoothly curved bend through an acute angle as in example (g). The various embodiments also include other shapes of the metal traces in local common bend zones as would be obvious to a person of ordinary skill in the relevant arts based on the disclosure of this application.

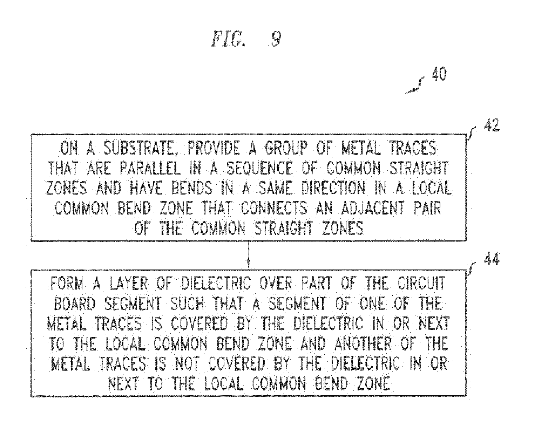

Figure 9 illustrates a process 40 for manufacturing a printed circuit board, e.g., for manufacturing any of the PCBs illustrated in Figures 1 - 3.

The process 40 includes providing, on a substrate, a group of metal traces, e.g., the metal traces 12₁ - 12₂ of Figure 1 (step 42). The metal traces of the group are parallel in a sequence of common straight zones, e.g., the zones 16₁ - 16₂ of Figure 1, and have bends in a same direction in a local common bend zone that connects and is located between a pair of adjacent ones of the common straight zones, e.g., the zone 18 of Figure 1.

The process 40 includes forming a layer of dielectric over part of the circuit board segment such that a segment of one of the metal traces is covered by the dielectric in or next to the local common bend zone and another of the metal traces is not covered by the dielectric in or next to the local common bend zone (step 44). For example, the layer of dielectric may be the dielectric layer 20 of Figure 1.

In the process 40, the one of the metal traces may optionally be located more along a bending direction of the metal traces in the local common bend zone than the other of the metal traces. For example, the metal trace 12₂ is located more along the direction of bending in the local common bend zone 18 of Figure 1 than the metal trace 12₁.

In the process 40, the dielectric may have a high dielectric constant, i.e., a value of 10 or more or even a value of 15 or more and, e.g., may be an oxide of a metal of the metal traces.

In the various embodiments, metal traces thereon may be formed of a variety of elemental metals and metal alloys. For example, such metal traces may be formed of copper, silver, aluminum, gold, or tin, or may be formed of common metal alloys including one or more of these metals.

In the various embodiments, the dielectric layers covering segments of metal traces in local common bend zones may be formed of various conventionally known dielectrics. For example, the dielectric layers 20 of Figures 1 - 2 and the dielectric layers 20₁ - 20_{P-1} of Figure 3 may be formed of various special dielectrics of high dielectric constants that are commonly used in micro-electronics and/or PCB fabrication.

In various embodiments, the PCBs may have metal traces on a single surface or interface of the PCB or may have multiple layers of metal traces on the PCB. That is, the PCB may have multiple layers of metal traces so that each layer of metal traces is on one interface or surface of a multilayer PCB. In such multilayer PCBs, the structures for locally reducing the production of signal skew, as described herein, may be used for one or more of such layers of metal traces.

Whereas Figures 1 - 6 illustrate configurations where a dielectric layer is patterned to differently cover and/or be in contact with top surfaces of the metal traces of a substantially parallel group in and/or next to a local common bend zone, configurations in which such a patterned dielectric layer covers and/or is differently in contact with bottom surface(s) of metal traces of such a group in and/or next a local common bend zone are also within the scope of the inventions. Indeed, if such metal traces are made such that the metal trace of shorter length in a local common bend zone is formed on a portion of the PCB with a higher dielectric constant, the local common bend zone may generate less skew between the electrical signals carried by the different metal traces of the group than in the absence of such lateral spatial patterning of the value of the dielectric constant at the metal traces.

Although the present inventions have been illustrated by reference to illustrative embodiments, the inventions are not limited to the illustrative embodiments and may include various changes and/or modifications. The scope of the invention is indicated by the appended claims rather than by the foregoing description.

## Claims

1. An apparatus comprising a printed circuit board, the printed circuit board comprising
a group of metal traces located along a surface or interface of the printed circuit board, the metal traces of the group being parallel in a sequence common straight zones and being bent in a common direction in a local common bend zone located between two of the common straight zones; and
a dielectric layer; and
wherein in and next to the local common bend zone, said same dielectric layer is in contact with a longer segment of one of the metal traces than of another of the metal traces of the group.

2. The apparatus of claim 1, wherein in the local common bend zone, the one of the metal traces is relatively located more along a bending direction of the metal traces therein than the another of the metal traces.

3. The apparatus of claim 1, wherein the metal traces of the group are fabricated of the same metal and have the about same cross sectional area.

4. The apparatus of claim 1, 2, or 3, wherein the dielectric layer has a dielectric constant of 10 or more.

5. The apparatus of claim 1, 2, or 3, wherein the dielectric layer includes metal oxide.

6. The apparatus of claim 1, 2, or 3, wherein the dielectric layer includes copper oxide and the metal traces include copper.

7. The apparatus of claim 1, 2 or 3, wherein the group includes at least three of the metal traces.

8. The apparatus of claim 7 further comprising a digital data bus being located on the printed circuit board and including the group of metal traces.

9. The apparatus of claim 8 further including a digital data processor module and a data memory module being located on the printed circuit board and being connected to communicate by the digital data bus.

10. The apparatus of claim 1, 2 or 3 further including a first electronic module and a second electronic module, the first and second electronic modules being located on the printed circuit board; and
wherein the metal traces of the group electrically connect a pair of differential signal outputs of the first electronic module to a pair of differential signal inputs of the second electronic module in a one-to-one manner.

11. The apparatus of claim 1, 2, or 3, wherein in and next to the local common bend zone, the dielectric layer is in contact with a shorter segment of a third of the metal traces than the one of the metal traces and the dielectric layer is in contact with a longer segment of third of the metal traces than the another of the metal traces.

12. The apparatus of claim 1, 2, 3, 8, or 9, wherein the metal traces of the group pass through a second local common bend zone in which the metal traces bend in the same direction, and in the second local common bend zone, a dielectric layer is in contact with a longer segment of one of the metal traces of the group than another of the metal traces of the group.

13. A process for manufacturing a printed circuit board comprises:
providing on a substrate the group of metal traces, the metal traces of the group being parallel in a sequence of common straight zones and having bends in a same direction in a local common bend zone located between two of the common straight zones; and
forming a layer of dielectric over part of the circuit board segment such that a segment of one of the metal traces is covered by the dielectric in or next to the local common bend zone and another of the metal traces is not covered by the same dielectric in or next to the local common bend zone.

14. The process of claim 13, wherein in the local common bend zone, the one of the metal traces is relatively located more along a bending direction of the metal traces than the another of the metal traces.

15. The process of claim 1, 2, or 3, wherein the dielectric has a dielectric constant of 10 or more.
